Europäisches Patentamt

European Patent Office

Office européen des brevets

(19)

(11) Publication number: **0 109 805**

**A2**

(12) **EUROPEAN PATENT APPLICATION**

(21) Application number: **83306859.6**

(22) Date of filing: **10.11.83**

(51) Int. Cl.³: **H 05 K 13/04**

(30) Priority: **17.11.82 GB 8232776**

(43) Date of publication of application:
**30.05.84 Bulletin 84/22**

(84) Designated Contracting States:
**BE DE FR GB IT LU NL**

(71) Applicant: **PLESSEY OVERSEAS LIMITED**
**Vicarage Lane**
**Ilford Essex IGI 4AQ(GB)**

(72) Inventor: **Shaw, Victor Henry**
**97 Yourk Road**
**Broadstone Dorset BH18 8EP(GB)**

(74) Representative: **Hart, Robert John**
**Plessey Telecommunications Limited Edge Lane**
**Liverpool L7 9NW(GB)**

(54) Pin punch and insertion machine.

(57) The machine positions pins on variable centres and uses the pins both to punch the hole and provide the registration pin for the board stack. The unique part and function of the invention is believed to be that it uses a compressed air supply only by way of a pneumatic intensifier to raise the hydraulic pressure to 2400 lbs which drives two hydraulic "Powerlode" clamp units. These clamp units operate a spring loaded hollow punch which is driven over the pin to be fitted to the board. Another feature of the invention is that the pins are fed to the loading position by a pneumatic ram which relies on its designed shape to take up the pin upon its emergence from the magazine, and feed and lock it into its finally located position.

EP 0 109 805 A2

./...

Fig. 1

TITLE:  PIN PUNCH AND INSERTION MACHINE

The present invention relates to a pin punch and insertion machine for use in manufacturing stacks of base boards for electrical equipment for example.

Hereto it has been the practice in the manufacture of stacked base boards for electrical equipment to drill or pierce the base boards before inserting the pins.

It is an object of the present invention to provide a machine which is capable of positioning a pin on a variable centre with respect to a base board and to use the pin both to punch and insert it in one action.

According to the invention there is provided a machine for use in manufacturing stacks of base boards, the machine including at least a pair of hydraulic clamp units driven from a pneumatic intensifier fed from a low pressure air supply, the clamp units operating upon a spring loaded hollow punch which co-operates with the pin to be fitted to the board.

According to a feature of the invention the pins are fed to the loading position by the use of a pneumatic ram which relies on its designed shape to take up the pin upon its emergence from a magazine and to feed and lock the pin into its finally located place.

The machine is ideally suited for use in the manufacture of stacked printed circuit boards.

The invention together with its features will be more readily understood from the following description which should be read in conjunction with the accompanying drawings. Of the drawings

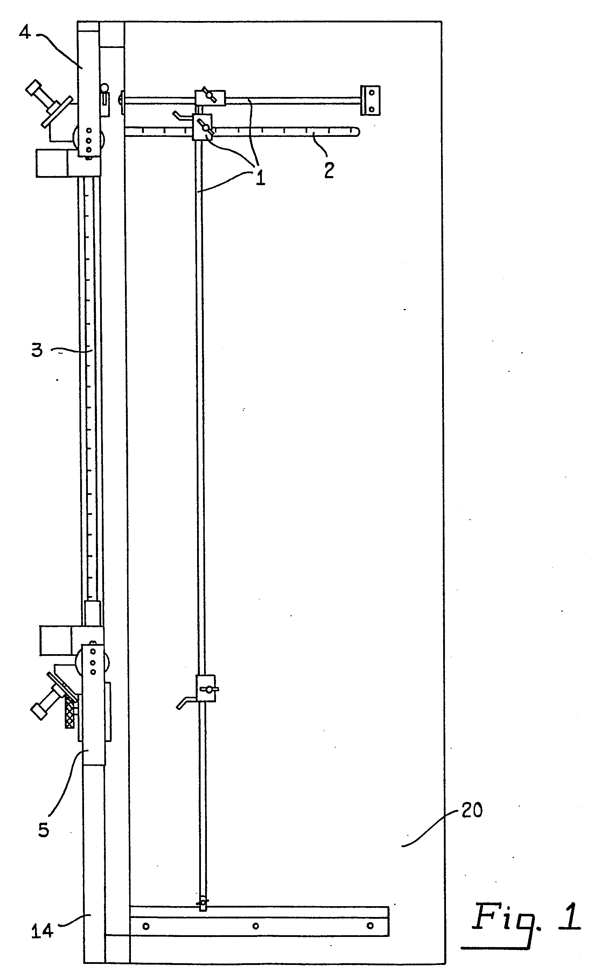

Fig 1 shows a plan view of the machine,

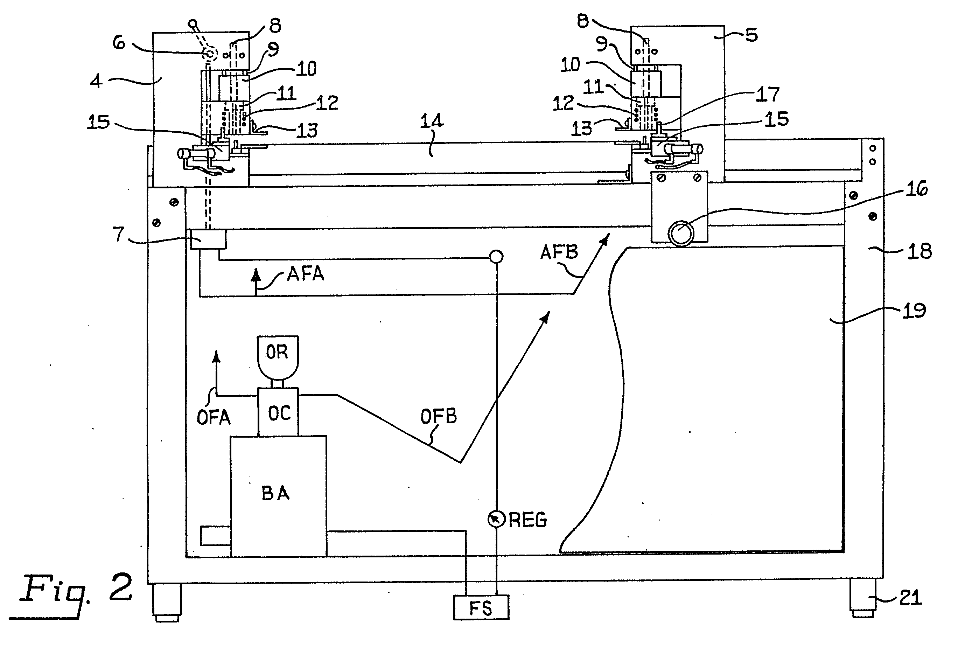

Fig 2 shows a front elevation view of the machine while

Fig 3 shows the details of the pin feed unit used in the machine.

The machine includes location bars and adjustable stops 1 arranged to co-operate with a vertical scale 2 and a horizontal scale 3 to locate the boards, of the board stack to be manufactured, on the top plate 20 of the machine. Two press heads 4 and 5 are provided comprising power lock clamp units 10 co-operating with pin accommodating hollow punches 11 which are spring loaded by return springs 12. Each press head 4 and 5 includes a slug disposal tube 8. Each clamp unit is provided with locking clamp screws 9 and each press head is provided with guards 13.

The machine incorporates an air supply control switch 7 which is operated by a cam 6 by way of a rod to control the connection of a low pressure air supply (typically of the order of .80 p.s.i)through air feed pipes AFA and AFB to the pin feed units 15 of each press head 4 and 5 and to an air booster unit BA which drives the hydraulic system for the power lock clamp units. The hydraulic system comprises an oil cylinder operated by the air booster unit and an oil reservoir OR. The oil cylinder feeds the oil by feed pipes OFA and OFB to the clamp units 4 and 5 respectively unit 5 being adjustably located and being fed by a flexible feed pipe OFB. The air booster BA is controlled by a foot switch FS and the booster transforms the 80 p.s.i. supply to provide a hydraulic pressure of the order of 2400 p.s.i. The low pressure air supply is fed to the foot switch FS through a regulator REG.

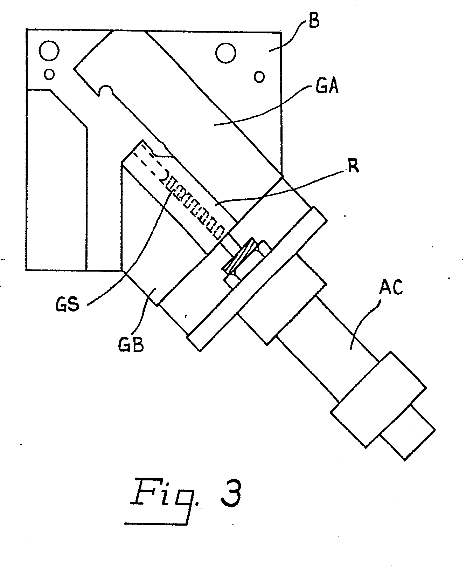

The adjustable press head 5 is provided with a locking screw 16 and each head includes a pin feed unit 15 which is shown in detail in Fig 3. The pin feed unit 15 comprises a base B a pair of pin guides GA and GB. Guide GA is contoured so as to take up the pin upon its emergence from a magazine 17 to feed and lock the pin into its finally located position. The guides accommodate a ram R which is driven from a piston shaft locked to the ram by a grub screw GS. The piston is driven under air control from switch 7 by a double acting air cylinder AC.

The machine is mounted on a case frame 18 and the air and hydraulic equipment is incorporated within the case and behind doors 19.

In operation the magazine 17 is loaded with pins and each head is loaded with a pin upon the operation of the cam 6 through air switch 7 and the pin feed units 15. A board to be pinned is then located to the stops and location bars 1 and the adjustable head is correctly located. The foot switch FS is then operated which activates the heads to punch the pins into the board. The operations are repeated as required for the number of boards in a stack. The cam lever is moved to unload and the boards are removed. Both pins are pierced simultaneously through boards which are introduced singly until the board stack is three boards high. It may also be used to pierce the drill backing board at the same time. The machine thus avoids the separate operations of drilling or piercing followed by pin insertion. Indeed the pins are not subject to the same wear as drills, being used far fewer times. The action of using the pin to pierce the blank also produced a tighter registration fit.

The machine has been produced for use in a printed circuit board manufacturing environment but the techniques used are not necessarily confined to piercing p.c.b. blanks.

Claims:-

1.    A machine for use in manufacturing stacks of base boards, the machine including at least a pair of hydraulic clamp units driven from a pneumatic intensifier fed from a low pressure air supply, the clamp units operating upon a spring loaded hollow punch which co-operates with the pin to be fitted to the board.

2.    A machine as claimed in claim 1 in which the pins are fed to the clamp units by the use of a pneumatic ram which relies upon its designed shape to take up the pin upon its emergence from a magazine and to feed and lock the pin into its finally located place.

3.    A machine as claimed in claim 2 in which one of the clamp units is fixed and one is adjustable and the machine includes horizontal and vertical sealing arrangements.

Fig. 1

Fig. 2

2/3

0109805

Fig. 3